# EUROPEAN PATENT SPECIFICATION

(11) **EP 4 456 680 B1**
(45) Date of publication and mention of the grant of the patent: **17.09.2025**
(21) Application number: 21968906.4
(22) Date of filing: 22.12.2021
(51) Int. Cl.: H05K 3/30, H05K 3/32, B33Y 10/00, H05K 1/18, H05K 3/12

(54) **ELECTRICAL CIRCUIT FORMING METHOD AND ELECTRICAL CIRCUIT FORMING APPARATUS**
VERFAHREN UND VORRICHTUNG ZUR HERSTELLUNG EINER ELEKTRISCHEN SCHALTUNG
PROCÉDÉ DE FORMATION DE CIRCUIT ÉLECTRIQUE ET APPAREIL DE FORMATION DE CIRCUIT ÉLECTRIQUE

(43) Date of publication of application: 30.10.2024
(73) Proprietor: Fuji Corporation, Chiryu-shi, Aichi 472-8686 (JP)
(72) Inventor: TSUKADA, Kenji, Chiryu-shi, Aichi 472-8686 (JP)
(74) Representative: Grünecker Patent- und Rechtsanwälte PartG mbB
(86) International application number: PCT/JP2021/047510
(87) International publication number: WO 2023/119469

(56) References cited:
- WO-A1-2020/079744
- WO-A1-2021/075051
- JP-A- 2001 332 846
- JP-A- 2004 363 434
- JP-A- H0 730 236
- JP-A- H0 794 856
- US-A1- 2010 052 163

## Description

### Technical Field

The present invention relates to an electrical circuit forming method and an electrical circuit forming apparatus for electrically connecting a metal wiring and an electronic component.

### Background Art

The following Patent Literature describes an electrical circuit forming method for electrically connecting a metal wiring and an electronic component.

### Patent Literature

Patent Literature 1: JP-A-2001-007503
Patent Literature 2: WO 2020/079744 A1 discloses an electrical circuit forming method comprising: coating a curable viscous fluid on a base and forming protrusions by curing the curable viscous fluid; forming wirings by coating a metal-containing liquid including nanometer-sized metal fine particles and firing the metal-containing liquid conductive; coating a resin paste including micrometer-sized metal particles on the protrusions and the wirings so as to connect the protrusions and the wiring; and a component placement step of placing a component having electrodes so that the electrodes come into contact with the resin paste coated on the protrusions.

Further relevant background art is disclosed in Patent Literature 3: JP H07 94856 A and Patent Literature 4: US 2010/052163 A1.

### Summary of the Invention

### Technical Problem

An object of the present description is to appropriately electrically connect a metal wiring and an electronic component.

### Solution to Problem

In order to solve the above problems, the present description discloses an electrical circuit forming method including a wiring forming step of forming a metal wiring on a resin layer, a first application step of applying a conductive fluid to a planned mounting position of an electrode of an electronic component on the metal wiring, a first curing step of curing the conductive fluid applied in the first application step, a second application step of applying a curable resin to a planned mounting position of a component main body of the electronic component, a second curing step of semi-curing the curable resin applied in the second application step, a mounting step of mounting the electronic component such that the electrode comes into contact with the conductive fluid cured in the first curing step and the component main body comes into contact with the curable resin semi-cured in the second curing step, and a third curing step of curing the curable resin semi-cured in the second curing step, after the electronic component is mounted in the mounting step.

In order to solve the above problems, the present description also discloses an electrical circuit forming apparatus including a wiring forming device configured to form a metal wiring on a resin layer, a first application device configured to apply a conductive fluid to a planned mounting position of an electrode of an electronic component on the metal wiring, a first curing device configured to cure the conductive fluid applied by the first application device, a second application device configured to apply a curable resin to a planned mounting position of a component main body of the electronic component, a second curing device configured to semi-cure the curable resin applied by the second application device, and a mounting device configured to mount the electronic component such that the electrode comes into contact with the conductive fluid cured by the first curing device and the component main body comes into contact with the curable resin semi-cured by the second curing device, in which the second curing device is configured to cure the semi-cured curable resin after the electronic component is mounted by the mounting device.

### Advantageous Effect of the Invention

In the present disclosure, the conductive fluid is applied to the planned mounting position of the electrode of the electronic component on the metal wiring, and the conductive fluid is cured. Next, the curable resin is applied to the planned mounting position of the component main body of the electronic component, and the curable resin is semi-cured. Subsequently, the electronic component is mounted such that the electrode comes into contact with the cured conductive fluid and the component main body comes into contact with the semi-cured curable resin. After the electronic component is mounted, the semi-cured curable resin is cured. As a result, the metal wiring and the electronic component can be electrically connected appropriately.

### Brief Description of Drawings

Fig. 1 is a diagram illustrating a circuit forming apparatus.
Fig. 2 is a block diagram illustrating a control device.
Fig. 3 is a cross-sectional view illustrating a heat-sensitive release film attached onto a base plate.
Fig. 4 is a cross-sectional view illustrating a circuit board in a state where a resin stack is formed.
Fig. 5 is a cross-sectional view illustrating the circuit board in a state where a wiring is formed on the resin stack.
Fig. 6 is a cross-sectional view illustrating the circuit board in a state where a conductive resin paste is applied onto the wiring.
Fig. 7 is a cross-sectional view illustrating the circuit board in a state where an electronic component is mounted such that an electrode is in contact with the conductive resin paste.
Fig. 8 is a cross-sectional view illustrating the circuit board in a state where a thermosetting resin is applied to a planned mounting position of a component main body.
Fig. 9 is a cross-sectional view illustrating the circuit board in a state where the electronic component is mounted such that the electrode is in contact with the conductive resin paste and the component main body is in contact with the thermosetting resin.
Fig. 10 is a cross-sectional view illustrating the circuit board in a state of being heated while being compressed.
Fig. 11 is a cross-sectional view illustrating the circuit board in a state where the thermosetting resin is discharged around the electronic component.
Fig. 12 is a cross-sectional view illustrating the circuit board in a state of being heated while being compressed. It is a cross-sectional view illustrating a circuit.

### Description of Embodiments

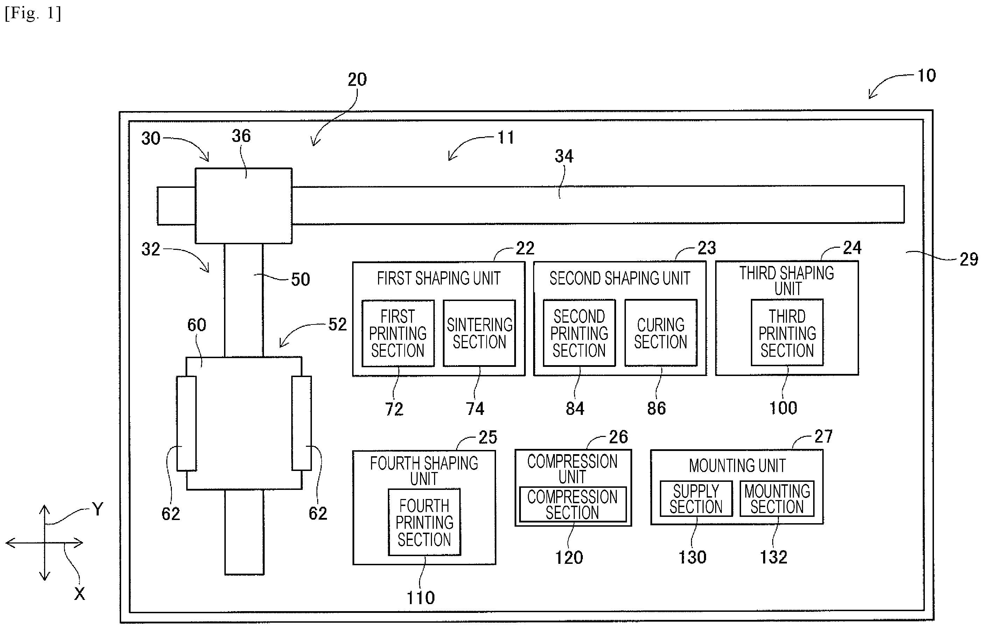

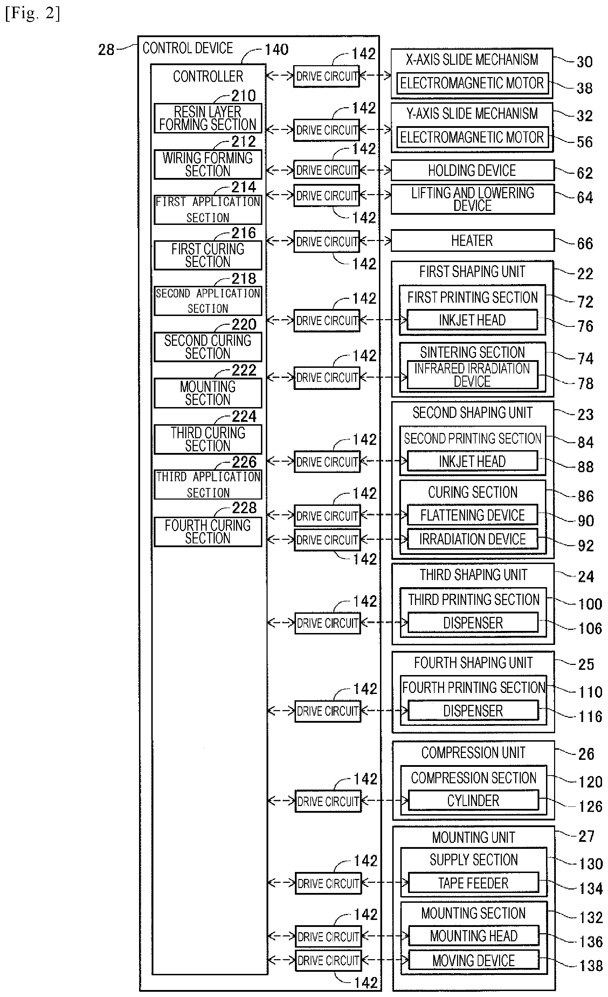

Fig. 1 illustrates circuit forming apparatus 10. Circuit forming apparatus 10 includes conveyance device 20, first shaping unit 22, second shaping unit 23, third shaping unit 24, fourth shaping unit 25, compression unit 26, mounting unit 27, and control device 28 (refer to Fig. 2). Conveyance device 20, first shaping unit 22, second shaping unit 23, third shaping unit 24, fourth shaping unit 25, compression unit 26, and mounting unit 27 are disposed on base 29 of circuit forming apparatus 10. Base 29 has a generally rectangular shape, and in the following description, a longer direction of base 29 will be referred to as an X-axis direction, a shorter direction of base 29 will be referred to as a Y-axis direction, and a direction orthogonal to both the X-axis direction and the Y-axis direction will be referred to as a Z-axis direction.

Conveyance device 20 is provided with X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Furthermore, X-axis slide mechanism 30 includes electromagnetic motor 38 (refer to Fig. 2), and X-axis slider 36 is moved to any position in the X-axis direction by driving electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end portion of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor 56 (refer to Fig. 2), and stage 52 is moved to any position in the Y-axis direction by driving electromagnetic motor 56. As a result, stage 52 is moved to any position on base 29 with the driving of X-axis slide mechanism 30 and Y-axis slide mechanism 32.

Stage 52 includes base plate 60, holding device 62, lifting and lowering device 64 (refer to Fig. 2), and heater 66 (refer to Fig. 2). Base plate 60 is formed in a flat plate shape, and a board is placed on an upper surface thereof. Holding devices 62 are provided on both side portions of base plate 60 in the X-axis direction. The board is fixedly held by sandwiching both edge portions of the board placed on base plate 60 in the X-axis direction with holding devices 62. In addition, lifting and lowering device 64 is disposed below base plate 60, and lifts and lowers base plate 60. In addition, heater 66 is incorporated in base plate 60 and heats the board placed on base plate 60 to any temperature.

First shaping unit 22 is a unit that shapes a wiring of a circuit board, and includes first printing section 72 and sintering section 74. First printing section 72 includes inkjet head 76 (refer to Fig. 2), and inkjet head 76 linearly discharges metal ink. The metal ink is ink obtained by dispersing nanometer-sized metal, for example, silver fine particles in a solvent. Surface of the metal fine particles are coated with a dispersant and aggregation in the solvent is prevented. In addition, inkjet head 76 discharges the metal ink from multiple nozzles by, for example, a piezo method using a piezoelectric element.

Sintering section 74 includes infrared irradiation device 78 (refer to Fig. 2). Infrared irradiation device 78 is a device for irradiating the discharged metal ink with infrared light, and the metal ink irradiated with infrared light is sintered to form the wiring. Sintering of the metal ink is, for example, a phenomenon in which evaporation of a solvent or decomposition of a protective film of metal fine particles, that is, a dispersant, or the like is performed by applying energy, so that conductivity is increased by contacting or fusing the metal fine particles. The metal ink is sintered to form a metal wiring.

In addition, second shaping unit 23 is a unit that shapes a resin layer of a circuit board, and includes second printing section 84 and curing section 86. Second printing section 84 includes inkjet head 88 (refer to Fig. 2), and inkjet head 88 discharges an ultraviolet curable resin. The ultraviolet curable resin is a resin that is cured by irradiation with ultraviolet light. Inkjet head 88 may be, for example, a piezo method using a piezoelectric element, or may be a thermal type in which a resin is heated to generate air bubbles, which are discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and makes the thickness of the ultraviolet curable resin uniform, for example, by scraping off excess resin by a roller or a blade while leveling the surface of the ultraviolet curable resin. In addition, irradiation device 92 includes a mercury lamp or LED as a light source, and irradiates the discharged ultraviolet curable resin with ultraviolet light. As a result, the discharged ultraviolet curable resin is cured to form the resin layer.

Third shaping unit 24 is a unit that shapes a connection section between the electrode of the electronic component and the wiring on the circuit board, and includes third printing section 100. Third printing section 100 includes dispenser 106 (refer to Fig. 2), and dispenser 106 discharges a conductive resin paste. The conductive resin paste is a paste in which micrometer-sized metal particles are dispersed in a resin cured by heating at a relatively low temperature. Incidentally, the metal particles are flake-shaped, and the viscosity of the conductive resin paste is relatively higher than that of the metal ink. The discharge amount of the conductive resin paste by dispenser 106 is controlled by the inner diameter of a needle, the pressure during discharge, and the discharge time.

The conductive resin paste discharged from dispenser 106 is heated by heater 66 incorporated in base plate 60, and the resin is cured in the heated conductive resin paste. In this case, in the conductive resin paste, the resin is cured and contracted, and the dispersed flake-shaped metal particles contact the resin. As a result, the conductive resin paste exhibits conductivity. In addition, the resin of the conductive resin paste is an organic adhesive, and exhibits an adhesive force when cured by heating.

Fourth shaping unit 25 is a unit that shapes resin for fixing the electronic component to the circuit board, and includes fourth printing section 110. Fourth printing section 110 includes dispenser 116 (refer to Fig. 2), and dispenser 116 discharges the thermosetting resin. The thermosetting resin is a resin that is cured by heating. Dispenser 116 is, for example, a piezo method using a piezoelectric element. The thermosetting resin discharged from dispenser 116 is heated by heater 66 incorporated in base plate 60 and is cured.

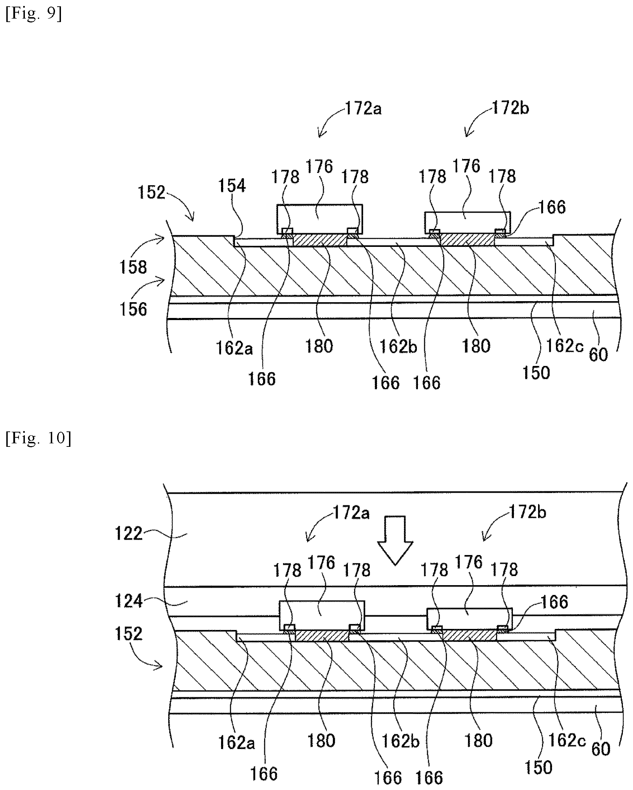

In addition, compression unit 26 is a unit for compressing the circuit board, and includes compression section 120. Compression section 120 includes compression plate 122 (refer to Fig. 10), rubber sheet 124 (refer to Fig. 10), and cylinder 126 (refer to Fig. 2). Rubber sheet 124 is made of silicone rubber and has a thick sheet shape. In addition, compression plate 122 is made of steel and has a plate shape. Rubber sheet 124 is attached to the lower surface of compression plate 122, and compression plate 122 is pressed toward the circuit board by the operation of cylinder 126. As a result, the circuit board is compressed by compression plate 122 via rubber sheet 124. Since the operation of cylinder 126 is controlled, the force for compressing the board can be controllably changed.

In addition, mounting unit 27 is a unit for mounting the electronic component on a circuit board, and includes supply section 130 and mounting section 132. Supply section 130 includes multiple tape feeders 134 (refer to Fig. 2) that feed the taped electronic components one by one, and supplies the electronic component to the supply position. Supply section 130 is not limited to tape feeder 134, and may be a tray-type supply device that supplies the electronic component by picking up the electronic component from a tray. In addition, supply section 130 may include both of the tape-type supply device and the tray-type supply device, or other supply devices.

Mounting section 132 includes mounting head 136 (refer to Fig. 2) and moving device 138 (refer to Fig. 2). Mounting head 136 includes a suction nozzle (not illustrated) for picking up and holding the electronic component. The suction nozzle picks up and holds the electronic component by suction of air as negative pressure is supplied from a positive and negative pressure supply device (not illustrated). As a slight positive pressure is supplied from the positive and negative pressure supply device, the electronic component is separated. In addition, moving device 138 moves mounting head 136 between the supply position of the electronic component by tape feeder 134 and the board placed on base plate 60. As a result, in mounting section 132, the electronic component supplied from tape feeder 134 is held by the suction nozzle, and the electronic component held by the suction nozzle is mounted on the board.

In addition, as illustrated in Fig. 2, control device 28 includes controller 140 and multiple drive circuits 142. Multiple drive circuits 142 are connected to electromagnetic motors 38 and 56, holding device 62, lifting and lowering device 64, heater 66, inkjet head 76, infrared irradiation device 78, inkjet head 88, flattening device 90, irradiation device 92, dispenser 106, dispenser 116, cylinder 126, tape feeder 134, mounting head 136, and moving device 138. Controller 140 includes CPU, ROM, RAM, or the like, mainly includes a computer, and is connected to multiple drive circuits 142. As a result, the operations of conveyance device 20, first shaping unit 22, second shaping unit 23, third shaping unit 24, fourth shaping unit 25, compression unit 26, and mounting unit 27 are controlled by controller 140.

With the configuration described above, in circuit forming apparatus 10, a resin stack is formed on base plate 60, and a wiring is formed on the upper surface of the resin stack. The electrode of the electronic component is electrically connected to the wiring via the conductive resin paste, and the electronic component is fixed with the resin to form a circuit board.

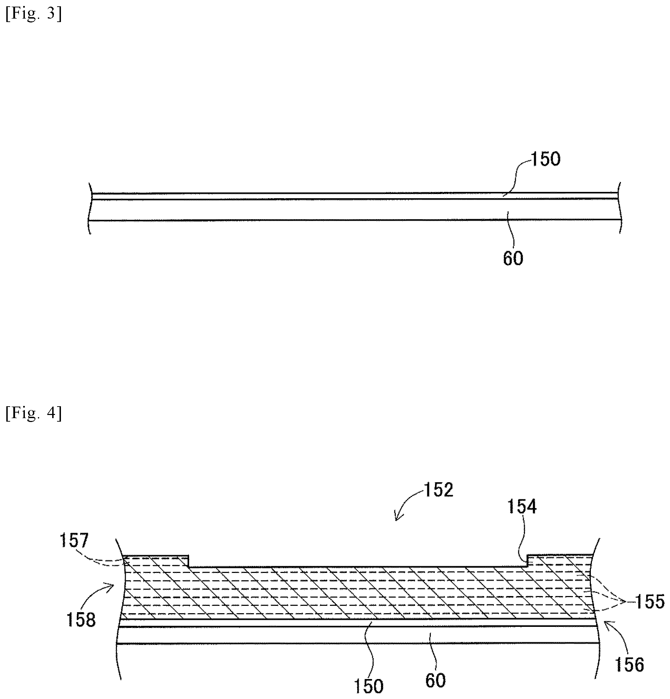

Specifically, as illustrated in Fig. 3, heat-sensitive release film 150 is first laid on the upper surface of base plate 60 of stage 52. Since heat-sensitive release film 150 has adhesiveness, heat-sensitive release film 150 appropriately adheres to the upper surface of base plate 60. A circuit board is formed on heat-sensitive release film 150, and the adherence of heat-sensitive release film 150 to base plate 60 prevents the deviation of the circuit board during circuit formation. Since the adhesiveness of heat-sensitive release film 150 decreases by heating, heat-sensitive release film 150 together with the circuit board formed on heat-sensitive release film 150 can be easily released from base plate 60 by heating heat-sensitive release film 150 after the circuit board is formed on heat-sensitive release film 150.

When heat-sensitive release film 150 is laid on base plate 60, stage 52 is moved below second shaping unit 23. In second shaping unit 23, as illustrated in Fig. 4, resin stack 152 is formed on heat-sensitive release film 150. Resin stack 152 has cavity 154 and is formed by repeating the discharge of the ultraviolet curable resin from inkjet head 88 and the irradiation with ultraviolet light by irradiation device 92 to the discharged ultraviolet curable resin.

Specifically, in second printing section 84 of second shaping unit 23, inkjet head 88 discharges the ultraviolet curable resin in a thin film shape on the upper surface of heat-sensitive release film 150. Subsequently, when the ultraviolet curable resin is discharged in a thin film shape, the ultraviolet curable resin is flattened by flattening device 90 in curing section 86 such that the ultraviolet curable resin has a uniform film thickness. Irradiation device 92 irradiates the ultraviolet curable resin in a thin film shape with ultraviolet light. As a result, resin layer 155 in the thin film shape is formed on heat-sensitive release film 150.

Subsequently, inkjet head 88 discharges the ultraviolet curable resin in a thin film shape onto resin layer 155 in the thin film shape. The ultraviolet curable resin in the thin film shape is flattened by flattening device 90, irradiation device 92 irradiates the ultraviolet curable resin discharged in a thin film shape with ultraviolet light, and thus resin layer 155 in the thin film shape is stacked on resin layer 155 in the thin film shape. As described above, the discharge of the ultraviolet curable resin on resin layer 155 in the thin film shape and the irradiation with the ultraviolet light are repeated, and multiple resin layers 155 are stacked, and thus first stack 156 is formed.

Next, inkjet head 88 discharges the ultraviolet curable resin such that a predetermined portion of the upper surface of first stack 156 is exposed. Subsequently, when the ultraviolet curable resin is discharged in a thin film shape, the ultraviolet curable resin is flattened in curing section 86 such that the ultraviolet curable resin has a uniform film thickness. Irradiation device 92 irradiates the ultraviolet curable resin in a thin film shape with ultraviolet light. As a result, resin thin film layer 157 is formed on first stack 156.

Subsequently, inkjet head 88 discharges the ultraviolet curable resin only on a portion on thin film layer 157 in a thin film shape. That is, inkjet head 88 discharges the ultraviolet curable resin on thin film layer 157 in a thin film shape such that a predetermined portion of the upper surface of first stack 156 is exposed. The ultraviolet curable resin in the thin film shape is flattened by flattening device 90, irradiation device 92 irradiates the ultraviolet curable resin discharged in a thin film shape with ultraviolet light, and thus thin film layer 157 is stacked on thin film layer 157. As described above, the discharge of the ultraviolet curable resin on thin film layer 157 and the irradiation with the ultraviolet light are repeated, and multiple thin film layers 157 are stacked, and thus second stack 158 is formed. As a result, by forming second stack 158 on first stack 156, resin stack 152 is formed in which the step portion between first stack 156 and second stack 158 functions as cavity 154.

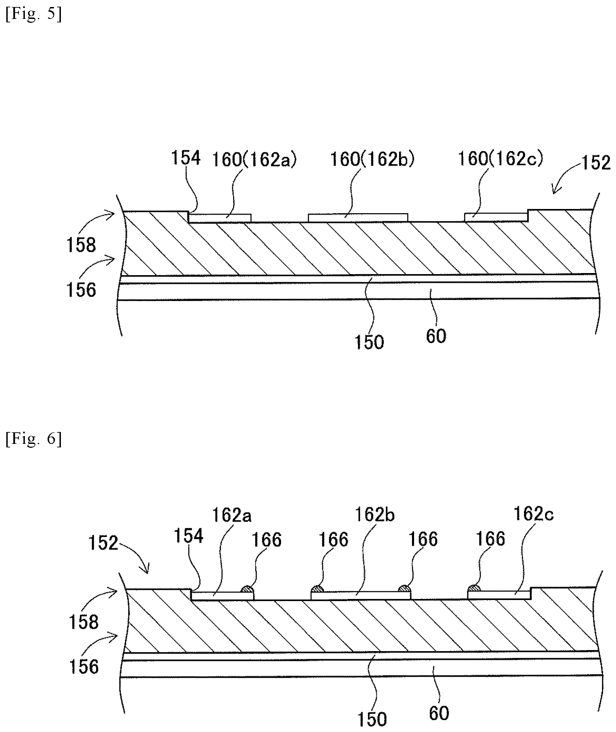

When resin stack 152 is formed by the above-described procedure, stage 52 is moved below first shaping unit 22. In first printing section 72 of first shaping unit 22, as illustrated in Fig. 5, inkjet head 76 linearly discharges metal ink 160 to cavity 154 of resin stack 152, that is, the upper surface of first stack 156 in accordance with the circuit pattern. Subsequently, infrared irradiation device 78 irradiates metal ink 160 discharged in accordance with the circuit pattern with infrared light in sintering section 74 of first shaping unit 22. As a result, metal ink 160 is sintered, and wiring 162 is formed in cavity 154. In Fig. 5, three wirings 162 are formed, but in a case where three wirings 162 are distinguished from each other, the wiring on the left side in Fig. 5 is described as wiring 162a, the wiring in the center is described as wiring 162b, and the wiring on the right side is described as wiring 162c.

Subsequently, when wiring 162 is formed in cavity 154 of resin stack 152, stage 52 is moved below third shaping unit 24. In third printing section 100 of third shaping unit 24, as illustrated in Fig. 6, dispenser 106 discharges conductive resin paste 166 onto both end portions of wiring 162b, and wiring 162a and wiring 162c facing both end portions of wiring 162b. As described above, when conductive resin paste 166 is discharged onto the end portion of wiring 162, resin stack 152 is heated by heater 66 incorporated in base plate 60 in accordance with the heating conditions of the conductive resin paste. As a result, conductive resin paste 166 is heated and cured via resin stack 152. The heating conditions of the conductive resin paste are heating conditions for completely curing the conductive resin paste, and are set by the manufacturer of the production source of the conductive resin paste. In addition, the heating conditions of the conductive resin paste are set according to the result of heating the conductive resin paste experimentally performed by the user of the conductive resin paste. As described above, conductive resin paste 166 is heated in accordance with the heating conditions of the conductive resin paste and completely cured, thereby exhibiting conductivity.

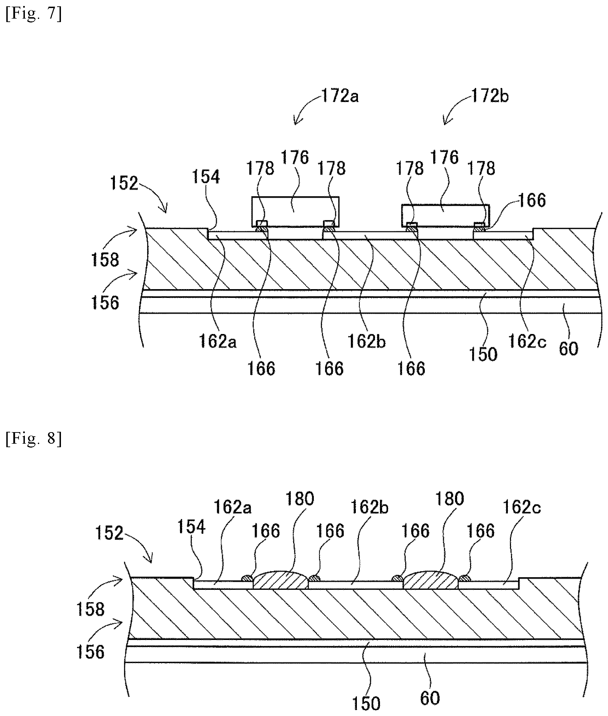

When conductive resin paste 166 discharged to the end portion of wiring 162 is completely cured by heating, stage 52 is moved below mounting unit 27. In mounting unit 27, electronic component 172 (refer to Fig. 7) is supplied by tape feeder 134, and electronic component 172 is held by the suction nozzle of mounting head 136. Electronic component 172 includes component main body 176 and two electrodes 178 disposed on the lower surface of component main body 176. Mounting head 136 is moved by moving device 138, and electronic component 172 held by the suction nozzle is mounted on the upper surface of resin stack 152 as illustrated in Fig. 7. In Fig. 7, two electronic components 172 are mounted on the upper surface of resin stack 152, and two electronic components 172 are different in size. Therefore, a large-sized electronic component is referred to as electronic component 172a, and a small-sized electronic component is referred to as electronic component 172b. Two electronic components 172a and 172b are mounted on the upper surface of resin stack 152 such that electronic component 172a is electrically connected to two wirings 162a and 162b and electronic component 172b is electrically connected to two wirings 162b and 162c.

Specifically, electronic component 172a is mounted such that electrode 178 is in contact with conductive resin paste 166 in a cured state on wirings 162a and 162b. In addition, electronic component 172b is mounted such that electrode 178 is in contact with conductive resin paste 166 in a cured state on wirings 162b and 162c. As a result, electronic component 172 and wiring 162 are electrically connected to each other via conductive resin paste 166 in a cured state.

However, since conductive resin paste 166 in a cured state has no adhesion to a component and has a low Young's modulus, there is a possibility that electronic component 172 mounted on contact with conductive resin paste 166 may be detached from conductive resin paste 166. Specifically, Young's modulus is a constant of proportionality between strain and stress in the elastic range, and is a ratio of the stress to the strain. Therefore, in a case where an object having a high Young's modulus and an object having a low Young's modulus are deformed at the same stress, the object having a low Young's modulus deforms more than the object having a high Young's modulus. That is, an object having a low Young's modulus is easily deformed. Therefore, when electrode 178 comes into contact with conductive resin paste 166 in a cured state, there is a possibility that conductive resin paste 166 may be deformed, and electronic component 172 may be detached from conductive resin paste 166 due to the elastic force of deformed conductive resin paste 166. As described above, when electronic component 172 is detached from conductive resin paste 166, the electrical connection between electronic component 172 and wiring 162 cannot be ensured.

Therefore, after the conductive resin paste is discharged onto wiring 162, it is conceivable to mount the electronic component such that the electrode is in contact with the conductive resin paste in an uncured state without heating the conductive resin paste. However, when the electronic component is mounted such that the electrode is in contact with the conductive resin paste in an uncured state, the conductive resin paste in an uncured state is crushed by the electrode, and the film thickness of the conductive resin paste is reduced. Even when the conductive resin paste is heated, since the conductive resin paste is liquefied like solder and is bonded in a state of being crushed and thinned without being deformed into an optimum shape, there is a possibility that large stress may be generated at a bonding portion between the electrode and the wiring. Specifically, as described above, resin stack 152 on which the electronic component is mounted is made of ultraviolet curable resin. Since the coefficient of thermal expansion of resin stack 152 made of ultraviolet curable resin is higher than that of a general circuit board, a large stress is generated at the bonding portion between the electrode and the wiring. Therefore, as the conductive resin paste interposed between the electrode and the wiring, the conductive resin paste having a low Young's modulus is adopted as described above. Since the film thickness of the conductive resin paste interposed between the electrode and the wiring is set to a predetermined thickness, when resin stack 152 is deformed, the conductive resin paste is deformed, so that the stress generated in the bonding portion between the electrode and the wiring is relaxed. However, when the conductive resin paste in an uncured state is crushed by the electrode and the film thickness of the conductive resin paste is reduced for mounting the electronic component, the deformation amount of the conductive resin paste is reduced, and the stress generated at the bonding portion between the electrode and the wiring cannot be appropriately relaxed. Therefore, when the electronic component is mounted such that the electrode is in contact with the conductive resin paste in an uncured state, there is a possibility that a large stress may be generated at the bonding portion between the electrode and the wiring.

Therefore, after the conductive resin paste discharged onto the wiring is cured, the thermosetting resin is discharged to a planned mounting position of the component main body of the electronic component, and the thermosetting resin is semi-cured. After the electronic component is mounted on the resin stack such that the electrode comes into contact with the conductive resin paste in the cured state and the component main body comes into contact with the thermosetting resin in the semi-cured state, the thermosetting resin in the semi-cured state is completely cured.

Specifically, as illustrated in Fig. 6, after conductive resin paste 166 is discharged onto wiring 162, the conductive resin paste is heated in accordance with the heating conditions of the conductive resin paste. As a result, the conductive resin paste is completely cured. Stage 52 moves below fourth shaping unit 25, and in fourth printing section 110 of fourth shaping unit 25, dispenser 116 discharges thermosetting resin 180 onto the upper surface of first stack 156 between wiring 162a and wiring 162b and onto the upper surface of first stack 156 between wiring 162b and wiring 162c as illustrated in Fig. 8. Since thermosetting resin 180 has a low viscosity, specifically, for example, 0.5 to 30 Pa·s, thermosetting resin 180 can be applied in a small amount, and can be suitably filled even in a fine gap or the like.

When thermosetting resin 180 is discharged onto the upper surface of first stack 156, resin stack 152 is heated under predetermined heating conditions by heater 66 incorporated in base plate 60. As a result, thermosetting resin 180 is heated and cured via resin stack 152. The heating conditions here are lower in heating temperature and shorter in heating time than the heating conditions for completely curing the thermosetting resin. Therefore, even when resin stack 152 is heated under predetermined heating conditions, the thermosetting resin is not completely cured, and is in an uncured state, that is, a semi-cured state. Therefore, the heating conditions here are referred to as semi-curing heating conditions of the thermosetting resin, and the heating conditions for completely curing the thermosetting resin are referred to as complete curing heating conditions. In the semi-curing heating conditions of the thermosetting resin, the heating temperature may be lower than that of the complete curing heating conditions of the thermosetting resin, and the heating time may be the same as that of the complete curing heating conditions. In addition, in the semi-curing heating conditions of the thermosetting resin, the heating time may be shorter than that of the complete curing heating conditions of the thermosetting resin, and the heating temperature may be the same as of that of the complete curing heating conditions.

As described above, when thermosetting resin 180 is heated and semi-cured under the semi-curing heating conditions, stage 52 is moved below mounting unit 27. In mounting unit 27, electronic component 172 is mounted on the upper surface of resin stack 152 as illustrated in Fig. 9. Specifically, electronic component 172a is mounted such that electrode 178 is in contact with conductive resin paste 166 in a cured state on wirings 162a and 162b. At this time, component main body 176 of electronic component 172a is discharged between wirings 162a and 162b and comes into contact with thermosetting resin 180 in a semi-cured state. In addition, electronic component 172b is mounted such that electrode 178 is in contact with conductive resin paste 166 in a cured state on wirings 162b and 162c. At this time, component main body 176 of electronic component 172b is discharged between wirings 162b and 162c and comes into contact with thermosetting resin 180 in a semi-cured state. That is, conductive resin paste 166 is discharged to a planned mounting position of electrode 178 on wiring 162, and thermosetting resin 180 is discharged to a planned mounting position of component main body 176. Therefore, when electronic component 172 is mounted on resin stack 152, electrode 178 comes into contact with conductive resin paste 166 in a cured state on wiring 162, and component main body 176 comes into contact with thermosetting resin 180 in a semi-cured state.

As described above, by mounting two electronic components 172a and 172b, electronic component 172a is electrically connected to two wirings 162a and 162b, and electronic component 172b is electrically connected to two wirings 162b and 162c. At this time, since electronic component 172 is mounted such that electrode 178 is in contact with conductive resin paste 166 in a cured state, conductive resin paste 166 is not crushed by electrode 178, and an appropriate film thickness of the conductive resin paste can be secured. However, since electrode 178 is in contact with conductive resin paste 166 in a cured state, the contact area between electrode 178 and conductive resin paste 166 is small. On the other hand, since component main body 176 of electronic component 172 is in contact with thermosetting resin 180 in a semi-cured state, the contact area between component main body 176 and thermosetting resin 180 is increased to some extent. Therefore, electronic component 172 is fixed to the upper surface of resin stack 152 in component main body 176 by the adhesive force of thermosetting resin 180. As a result, it is possible to appropriately prevent the positional deviation of electronic component 172.

As described above, when electronic component 172 is mounted on resin stack 152 such that electrode 178 comes into contact with conductive resin paste 166 in a cured state on wiring 162 and component main body 176 comes into contact with thermosetting resin 180 in a semi-cured state, stage 52 is moved below compression unit 26. In compression section 120 of compression unit 26, as illustrated in Fig. 10, electronic component 172 mounted on resin stack 152 is compressed from above to below by compression plate 122 via rubber sheet 124. At this time, as electronic component 172 is compressed downward, although thermosetting resin 180 in contact with the lower surface of component main body 176 is also compressed downward, since thermosetting resin 180 is semi-cured, seepage of thermosetting resin 180 to the electrodes, generation of voids, and the like are suppressed.

In addition, although two electronic components 172a and 172b are mounted on cavity 154 of resin stack 152, the depth dimension of cavity 154 is smaller than the height dimension of two electronic components 172. Therefore, the upper surfaces of two electronic components 172a and 172b extend upward from cavity 154, and two electronic components 172 can be compressed by compression plate 122 from above to below. In addition, since two electronic components 172 are different in size as described above, the height dimensions are also different, but rubber sheet 124 is attached to the lower surface of compression plate 122. As a result, when two electronic components 172a and 172b are compressed, rubber sheet 124 is elastically deformed, and thus two electronic components 172a and 172b having different height dimensions can be appropriately compressed.

In addition, when electronic component 172 is compressed in compression unit 26, resin stack 152 is heated by heater 66 incorporated in base plate 60 under the complete curing heating conditions of the thermosetting resin. As a result, thermosetting resin 180 is completely cured by being heated under the complete curing heating conditions through resin stack 152. That is, thermosetting resin 180 is completely cured in a state of being sealed between the upper surface of resin stack 152 and the lower surface of component main body 176. In addition, when electronic component 172 is compressed, that is, when electronic component 172 mounted on resin stack 152 is pressed toward resin stack 152, conductive resin paste 166 in contact with electrode 178 is deformed, and the contact area between electrode 178 and conductive resin paste 166 increases. In particular, since Young's modulus of conductive resin paste 166 is low as described above, conductive resin paste 166 having a low Young's modulus is deformed by being pressed against electrode 178, and the contact area between electrode 178 and conductive resin paste 166 increases. As a result, the electrical connection between electronic component 172 and wiring 162 is ensured. In addition, when electronic component 172 mounted on resin stack 152 is pressed toward resin stack 152, thermosetting resin 180 in contact with component main body 176 is also deformed, and the contact area between component main body 176 and thermosetting resin 180 is also increased. As described above, by increasing the contact area between component main body 176 and thermosetting resin 180, electronic component 172 can be suitably fixed to resin stack 152 by the adhesive force of thermosetting resin 180.

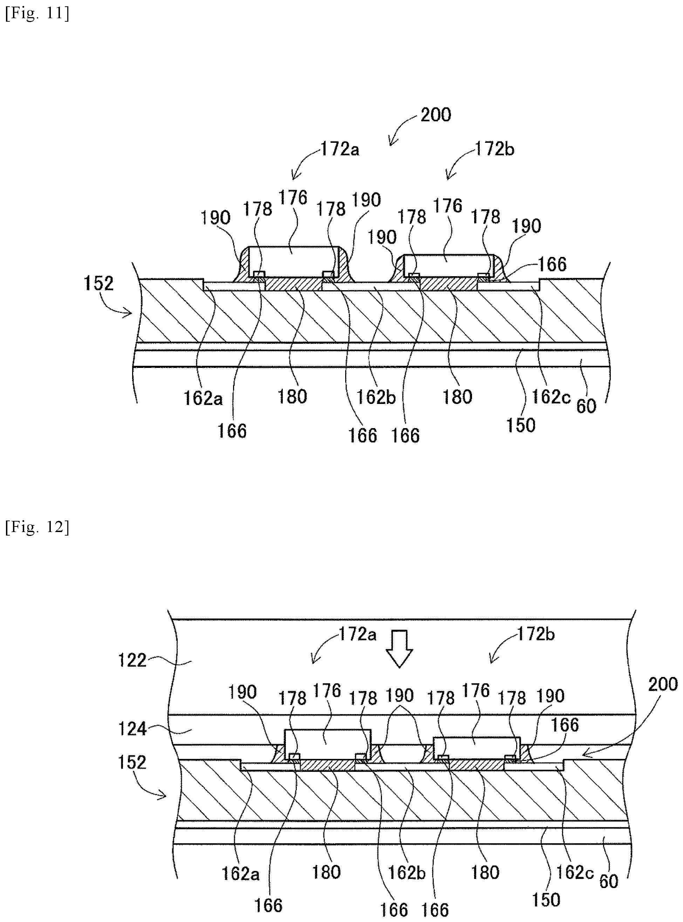

When the compression by compression plate 122 in compression unit 26 is completed, stage 52 is moved below fourth shaping unit 25. In fourth printing section 110 of fourth shaping unit 25, dispenser 116 discharges thermosetting resin 190 around electronic component 172 to cover the side surface of component main body 176 of electronic component 172, as illustrated in Fig. 11. Resin stack 152 is heated by heater 66 incorporated in base plate 60 under the complete curing heating conditions of the thermosetting resin. As a result, thermosetting resin 190 is heated under complete curing heating conditions via resin stack 152 and completely cured. As a result, thermosetting resin 190 is cured in a state of covering the side surface of component main body 176. That is, in electronic component 172 mounted on resin stack 152, thermosetting resins 180 and 190 are sealed between the upper surface of resin stack 152 and the lower surface of component main body 176, and are cured in a state of covering the side surface of component main body 176. As a result, electronic component 172 mounted on the upper surface of resin stack 152 is fixed by the cured resin.

As described above, by fixing electronic component 172 mounted on the upper surface of resin stack 152 to the cured resin, circuit board 200 is formed on heat-sensitive release film 150 on the upper surface of base plate 60. In order to release heat-sensitive release film 150 from formed circuit board 200, although heat-sensitive release film 150 is heated by heater 66 incorporated in base plate 60, at this time, circuit board 200 is also heated, and there is a possibility that circuit board 200 may be warped. Therefore, when heat-sensitive release film 150 is heated, heat-sensitive release film 150 is heated while compressing circuit board 200.

Therefore, when electronic component 172 mounted on the upper surface of resin stack 152 is fixed by curing of thermosetting resin 190, stage 52 is moved below compression unit 26. In compression section 120 of compression unit 26, as illustrated in Fig. 12, entire circuit board 200 is compressed downward by compression plate 122 via rubber sheet 124. At this time, during compression by compression plate 122, heat-sensitive release film 150 is heated by heater 66 incorporated in base plate 60. As a result, the adhesiveness of heat-sensitive release film 150 decreases, and circuit board 200 can be easily released from base plate 60 together with heat-sensitive release film 150. Heat-sensitive release film 150 is released from circuit board 200, and thus the formation of circuit board 200 is completed.

Since circuit board 200 is formed by such a method, it is possible to secure an appropriate film thickness of conductive resin paste 166 between electrode 178 of electronic component 172 and wiring 162, and to appropriately prevent positional deviation of the electronic component by thermosetting resin 180 in a semi-cured state. As a result, it is possible to form a circuit capable of appropriately relaxing the stress generated in the bonding portion between electrode 178 and wiring 162 and appropriately ensuring the electrical connection between electronic component 172 and wiring 162.

As illustrated in Fig. 2, controller 140 of control device 28 includes resin layer forming section 210, wiring forming section 212, first application section 214, first curing section 216, second application section 218, second curing section 220, mounting section 222, third curing section 224, third application section 226, and fourth curing section 228. Resin layer forming section 210 is a functional section for forming resin stack 152 using an ultraviolet curable resin. Wiring forming section 212 is a functional section for forming wiring 162 by metal ink 160. First application section 214 is a functional section for applying conductive resin paste 166 to a planned mounting position of electrode 178 on the wiring. First curing section 216 is a functional section for completely curing conductive resin paste 166 applied onto the wiring. Second application section 218 is a functional section for applying thermosetting resin 180 to the planned mounting position of component main body 176. Second curing section 220 is a functional section for semi-curing thermosetting resin 180 applied to the planned mounting position of the component main body. Mounting section 222 is a functional section for mounting electronic component 172 such that electrode 178 comes into contact with cured conductive resin paste 166 and component main body 176 comes into contact with semi-cured thermosetting resin 180. Third curing section 224 is a functional section for completely curing thermosetting resin 180 in contact with the component main body while compressing the electronic component. Third application section 226 is a functional section for applying thermosetting resin 190 around component main body 176. Fourth curing section 228 is a functional section for completely curing thermosetting resin 190 applied around the component main body.

In the above example, circuit forming apparatus 10 is an example of an electrical circuit forming apparatus. First shaping unit 22 is an example of a wiring forming device. Mounting unit 27 is an example of a mounting device. Heater 66 is an example of a first curing device and a second curing device. Dispenser 106 is an example of a first application device. Dispenser 116 is an example of a second application device. Rubber sheet 124 is an example of an elastic body. Resin stack 152 is an example of a resin layer. Wiring 162 is an example of a metal wiring. Conductive resin paste 166 is an example of a conductive fluid. Electronic component 172 is an example of an electronic component. Component main body 176 is an example of a component main body. Electrode 178 is an example of an electrode. Thermosetting resin 180 is an example of a curable resin. In addition, a step executed by wiring forming section 212 is an example of a wiring forming step. A step executed by first application section 214 is an example of a first application step. A step executed by first curing section 216 is an example of a first curing step. A step executed by second application section 218 is an example of a second application step. A step executed by second curing section 220 is an example of a second curing step. A step executed by mounting section 222 is an example of a mounting step. A step executed by third curing section 224 is an example of a third curing step. A step executed by third application section 226 is an example of a third application step. A step executed by fourth curing section 228 is an example of a fourth curing step.

The present invention is not limited to the example described above, and can be performed in various aspects to which various modifications and improvements are applied based on the knowledge of those skilled in the art. For example, in the above example, although the circuit board is compressed by compression plate 122 via rubber sheet 124, the circuit board may be compressed by compression plate 122 through various members as long as the member is elastically deformable. For example, a silicon-based resin, a urethane-based resin, or the like can be adopted as the elastically deformable member.

In addition, in the above example, although conductive resin paste 166 is adopted as a fluid that electrically connects wiring 162 and electrode 178 of electronic component 172, various fluids can be adopted as long as the fluid exhibits conductivity.

In addition, in the above embodiment, although the thermosetting resin is adopted as the curable resin for fixing electronic component 172, an ultraviolet curable resin, a two-liquid mixed curable resin, a thermoplastic resin, and the like may be adopted. In addition, in the above example, the ultraviolet curable resin is adopted as a resin forming resin stack 152, and the thermosetting resin is adopted as a resin fixing electronic component 172. That is, although the resin forming resin stack 152 and the resin fixing electronic component 172 are different curable resins, the resin forming resin stack 152 and the resin fixing electronic component 172 may be the same curable resin.

In addition, in the above example, although the conductive resin paste is discharged by dispenser 106, the conductive resin paste may be transferred by a transfer device or the like. In addition, the conductive resin paste may be printed by screen printing.

### Reference Signs List

10: Circuit forming apparatus (electrical circuit forming apparatus), 22: First shaping unit (wiring forming device), 27: Mounting unit (mounting device), 66: Heater (first curing device) (second curing device), 106: Dispenser (first application device), 116: Dispenser (second application device), 124: Rubber sheet (elastic body), 152: Resin stack (resin layer), 162: Wiring (metal wiring), 166: Conductive resin paste (conductive fluid), 172: Electronic component, 176: Component main body, 178: Electrode, 180: Thermosetting resin (curable resin), 212: Wiring forming section (wiring forming step), 214: First application section (first application step), 216: First curing section (first curing step), 218: Second application section (second application step), 220: Second curing section (second curing step), 222: Mounting section (mounting step), 224: Third curing section (third curing step), 226: Third application section (third application step), 228: Fourth curing section (fourth curing step).

## Claims

1. An electrical circuit forming method comprising:
a wiring forming step of forming a metal wiring on a resin layer;
a first application step of applying a conductive fluid to a planned mounting position of an electrode of an electronic component on the metal wiring;
a first curing step of curing the conductive fluid applied in the first application step;
a second application step of applying a curable resin to a planned mounting position of a component main body of the electronic component;
a second curing step of semi-curing the curable resin applied in the second application step;
a mounting step of mounting the electronic component such that the electrode comes into contact with the conductive fluid cured in the first curing step and the component main body comes into contact with the curable resin semi-cured in the second curing step; and
a third curing step of curing the curable resin semi-cured in the second curing step, after the electronic component is mounted in the mounting step.

2. The electrical circuit forming method according to claim 1, wherein
in the third curing step, the curable resin is cured while pressing the electronic component toward the resin layer.

3. The electrical circuit forming method according to claim 2, wherein
in the third curing step, in a state where a plate-shaped elastic body is placed on the electronic component, the curable resin is cured while pressing the electronic component toward the resin layer via the elastic body.

4. The electrical circuit forming method according to any one of claims 1 to 3, further comprising:
a third application step of applying the curable resin to a periphery of the component main body after curing the curable resin in the third curing step; and
a fourth curing step of curing the curable resin applied in the third application step.

5. An electrical circuit forming apparatus comprising:
a wiring forming device configured to form a metal wiring on a resin layer;
a first application device configured to apply a conductive fluid to a planned mounting position of an electrode of an electronic component on the metal wiring;
a first curing device configured to cure the conductive fluid applied by the first application device;
a second application device configured to apply a curable resin to a planned mounting position of a component main body of the electronic component;
a second curing device configured to semi-cure the curable resin applied by the second application device; and
a mounting device configured to mount the electronic component such that the electrode comes into contact with the conductive fluid cured by the first curing device and the component main body comes into contact with the curable resin semi-cured by the second curing device,
wherein
the second curing device is configured to cure the semi-cured curable resin after the electronic component is mounted by the mounting device.

## Patentansprüche

1. Ein Verfahren zum Herstellen einer elektrischen Schaltung, umfassend:
einen Verdrahtungsschritt zum Herstellen einer Metallverdrahtung auf einer Harzschicht;
einen ersten Auftragsschritt zum Auftragen einer leitfähigen Flüssigkeit auf eine geplante Montageposition einer Elektrode eines elektronischen Bauteils auf der Metallverdrahtung;
einen ersten Aushärtungsschritt zum Aushärten der im ersten Auftragsschritt aufgetragenen leitfähigen Flüssigkeit;
einen zweiten Auftragsschritt zum Auftragen eines härtbaren Harzes auf eine geplante Montageposition eines Bauteilhauptkörpers des elektronischen Bauteils;
einen zweiten Aushärtungsschritt zum halbhärten des im zweiten Auftragungsschritt aufgetragenen härtbaren Harzes;
einen Montageschritt zum Montieren des elektronischen Bauteils, so dass die Elektrode mit der im ersten Aushärtungsschritt ausgehärteten leitfähigen Flüssigkeit in Kontakt kommt und der Hauptkörper des Bauteils mit dem im zweiten Aushärtungsschritt halb ausgehärteten aushärtbaren Harz in Kontakt kommt; und
einen dritten Aushärtungsschritt zum Aushärten des im zweiten Aushärtungsschritt halb ausgehärteten aushärtbaren Harzes, nachdem das elektronische Bauteil im Montageschritt montiert wurde.

2. Das Verfahren zum Herstellen einer elektrischen Schaltung gemäß Anspruch 1, wobei
im dritten Aushärtungsschritt das aushärtbare Harz ausgehärtet wird, während das elektronische Bauteil gegen die Harzschicht gedrückt wird.

3. Das Verfahren zum Herstellen einer elektrischen Schaltung gemäß Anspruch 2, wobei
im dritten Aushärtungsschritt in einem Zustand, in dem ein plattenförmiger elastischer Körper auf dem elektronischen Bauteil angeordnet ist, das aushärtbare Harz ausgehärtet wird, während das elektronische Bauteil über den elastischen Körper in Richtung der Harzschicht gedrückt wird.

4. Das Verfahren zum Herstellen einer elektrischen Schaltung gemäß einem der Ansprüche 1 bis 3, des Weiteren umfassend:
einen dritten Auftragsschritt, bei dem das härtbare Harz nach dem Aushärten des härtbaren Harzes im dritten Aushärtungsschritt auf einen Umfang des Bauteilhauptkörpers aufgetragen wird; und
einen vierten Auftragsschritt, bei dem das im dritten Auftragsschritt aufgetragene härtbare Harz ausgehärtet wird.

5. Eine Vorrichtung zum Herstellen einer elektrischen Schaltung, umfassend:
eine Verdrahtungsvorrichtung, die zum Herstellen einer Metallverdrahtung auf einer Harzschicht konfiguriert ist;
eine erste Auftragsvorrichtung, die zum Auftragen einer leitfähigen Flüssigkeit auf eine geplante Montageposition einer Elektrode eines elektronischen Bauteils auf der Metallverdrahtung konfiguriert ist;
eine erste Aushärtungsvorrichtung, die zum Aushärten der von der ersten Auftragsvorrichtung aufgetragenen leitfähigen Flüssigkeit konfiguriert ist;
eine zweite Auftragsvorrichtung, die zum Auftragen eines aushärtbaren Harzes auf eine geplante Montageposition eines Bauteilkörpers des elektronischen Bauteils konfiguriert ist;
eine zweite Aushärtungsvorrichtung, die konfiguriert ist, das von der zweiten Auftragsvorrichtung aufgetragene aushärtbare Harz halb auszuhärten; und
eine Montagevorrichtung, die konfiguriert ist, das elektronische Bauteil so zu montieren, dass die Elektrode mit dem von der ersten Aushärtungsvorrichtung ausgehärteten leitfähigen Fluid in Kontakt kommt und der Hauptkörper des Bauteils mit dem von der zweiten Aushärtungsvorrichtung halb ausgehärteten aushärtbaren Harz in Kontakt kommt, wobei
die zweite Aushärtungsvorrichtung konfiguriert ist, das halb ausgehärtete härtbare Harz auszuhärten, nachdem das elektronische Bauteil durch die Montagevorrichtung befestigt wurde.

## Revendications

1. Procédé de formation d'un circuit électrique, comprenant :
une étape de formation de câblage consistant à former un câblage métallique sur une couche de résine ;
une première étape d'application consistant à appliquer un fluide conducteur sur une position de montage prévue d'une électrode d'un composant électronique sur le câblage métallique ;
une première étape de durcissement consistant à faire durcir le fluide conducteur appliqué à la première étape d'application ;
une deuxième étape d'application consistant à appliquer une résine durcissable sur une position de montage prévue d'un corps principal de composant du composant électronique ;
une deuxième étape de durcissement consistant à semi-durcir la résine durcissable appliquée à la deuxième étape d'application ;
une étape de montage consistant à monter le composant électronique de telle sorte que l'électrode entre en contact avec le fluide conducteur durci lors de la première étape de durcissement et que le corps principal de composant entre en contact avec la résine durcissable semi-durcie à la deuxième étape de durcissement ; et
une troisième étape de durcissement consistant à durcir la résine durcissable semi-durcie à la deuxième étape de durcissement, après le montage du composant électronique à l'étape de montage.

2. Procédé de formation d'un circuit électrique selon la revendication 1, dans lequel
à la troisième étape de durcissement, la résine durcissable est durcie tout en poussant le composant électronique vers la couche de résine.

3. Procédé de formation d'un circuit électrique selon la revendication 2, dans lequel
à la troisième étape de durcissement, dans un état où un corps élastique en forme de plaque est placé sur le composant électronique, la résine durcissable est durcie tout en poussant le composant électronique vers la couche de résine via le corps élastique.

4. Procédé de formation d'un circuit électrique selon l'une quelconque des revendications 1 à 3, comprenant en outre :
une troisième étape d'application consistant à appliquer la résine durcissable sur une périphérie du corps principal de composant après avoir durci la résine durcissable à la troisième étape de durcissement ; et
une quatrième étape de durcissement consistant à faire durcir la résine durcissable appliquée à la troisième étape d'application.

5. Appareil de formation d'un circuit électrique, comprenant :
un dispositif de formation de câblage configuré pour former un câblage métallique sur une couche de résine ;
un premier dispositif d'application configuré pour appliquer un fluide conducteur à une position de montage prévue d'une électrode d'un composant électronique sur le câblage métallique ;
un premier dispositif de durcissement configuré pour durcir le fluide conducteur appliqué par le premier dispositif d'application ;
un deuxième dispositif d'application configuré pour appliquer une résine durcissable sur une position de montage prévue d'un corps principal de composant du composant électronique ;
un deuxième dispositif de durcissement configuré pour semi-durcir la résine durcissable appliquée par le deuxième dispositif d'application ; et
un dispositif de montage configuré pour monter le composant électronique de telle sorte que l'électrode entre en contact avec le fluide conducteur durci par le premier dispositif de durcissement et que le corps principal de composant entre en contact avec la résine durcissable semi-durcie par le deuxième dispositif de durcissement,
dans lequel
le deuxième dispositif de durcissement est configuré pour durcir la résine durcissable semi-durcie après que le composant électronique est monté par le dispositif de montage.
